(19) Europäisches Patentamt
European Patent Office
Office européen des brevets

(11) EP 1 072 092 B1

(12) EUROPEAN PATENT SPECIFICATION

(45) Date of publication and mention
of the grant of the patent:
**02.02.2005 Bulletin 2005/05**

(21) Application number: **99915944.5**

(22) Date of filing: **14.04.1999**

(51) Int Cl.⁷: **H03K 4/92**

(86) International application number:
**PCT/GB1999/001143**

(87) International publication number:
**WO 1999/053616 (21.10.1999 Gazette 1999/42)**

(54) **MONOPULSE GENERATOR**

MONOPULSGENERATOR

GENERATEUR POUR RADAR MONOPULSE

(84) Designated Contracting States:
**AT CH DE FI FR IT LI NL SE**

(30) Priority: **14.04.1998 GB 9807669**

(43) Date of publication of application:
**31.01.2001 Bulletin 2001/05**

(73) Proprietors:
• **ROKE MANOR RESEARCH LIMITED**
**Romsey, Hampshire SO51 0ZN (GB)**
• **The Secretary of State for Defence in her**
**Britannic Majesty's Gov. of the United Kingdom**
**of Great Britain and North Ireland**
**Farnborough, Hampshire GU14 0LX (GB)**

(72) Inventors:
• **STEVENS, Roderick, Leonard, Wallace**
**Eastleigh Hampshire SO53 4RG (GB)**

• **ROBSON, David, John**
**Bromley Kent BR2 7NB (GB)**

(74) Representative: **Allen, Derek**
**Siemens Shared Services Limited,**
**Intellectual Property Department,**
**Siemens House,**
**Oldbury**
**Bracknell, Berkshire RG12 8FZ (GB)**

(56) References cited:
**DE-C- 19 531 517          US-A- 5 239 696**
**US-A- 5 457 394**

• **R. P. MOORE: "Digital Phase Angle Meter**
**Control" IBM TECHNICAL DISCLOSURE**
**BULLETIN, vol. 3, no. 2, page 35 XP002110733**
**New York, US**

**Description**

The present invention relates to monopulse generators which operate to generate pulses of desired shape and energy for use *inter alia* in radar systems. Furthermore, the present invention relates to surface penetrating radar systems which operate to detect buried or submerged objects beneath an intervening surface.

Surface penetrating radar systems serve to detect anomalies and buried objects beneath the surface of the ground from electro-magnetic radio pulses reflected by those anomalies and objects. Examples of such objects are pipes which may be made of plastic and are difficult to detect by means other than by a surface penetrating radar system. Such pipes may be substantially thin and buried a substantial distance below the surface of the ground, thereby demanding that the accuracy with which the location of the pipe is detected is as high as possible.

As will be appreciated, surface penetrating radar systems operate to detect objects buried behind walls, ceilings, or any intervening surface.

Known surface penetrating radar systems are provided with monopulse generators, which generate pulses of electro-magnetic radiation. These pulses penetrate the surface and are reflected by the anomalies and objects. The reflections are thereafter detected by the surface penetrating radar system and from knowledge of a difference between a time when the electromagnetic pulses were transmitted and a time when the reflections were received, a location of those anomalies and objects below the surface, may be determined, in a plane corresponding to a direction in which the electromagnetic pulses travel.

Examples of such known surface penetrating radio systems are provided in a book entitled 'Surface Penetrating Radar' by D J Daniels, published by the Institute of Electrical Engineers.

US patent 5,239,696 discloses a transmitter for an electric article surveillance system having a power amplifier for forming a drive signal for causing a current to flow through an antenna. The magnitude of the current flowing through the antenna is sensed and subsequently used to control the drive signal. A master clock having an oscillator and a counter are used to form a square wave which is supplied to an elliptic filter which outputs a sine-wave at the system's operating frequency.

In order to determine a location of an anomaly to within a required accuracy, the monopulse generators are arranged to generate a substantially high energy wide band width pulse at a predetermined time. However, known surface penetrating radar systems suffer from a technical problem in that the monopulse generators can only reproduce a time at which the pulses are generated to a limited accuracy which thereby affects a resolution with which the location of the anomalies below the surface can be detected.

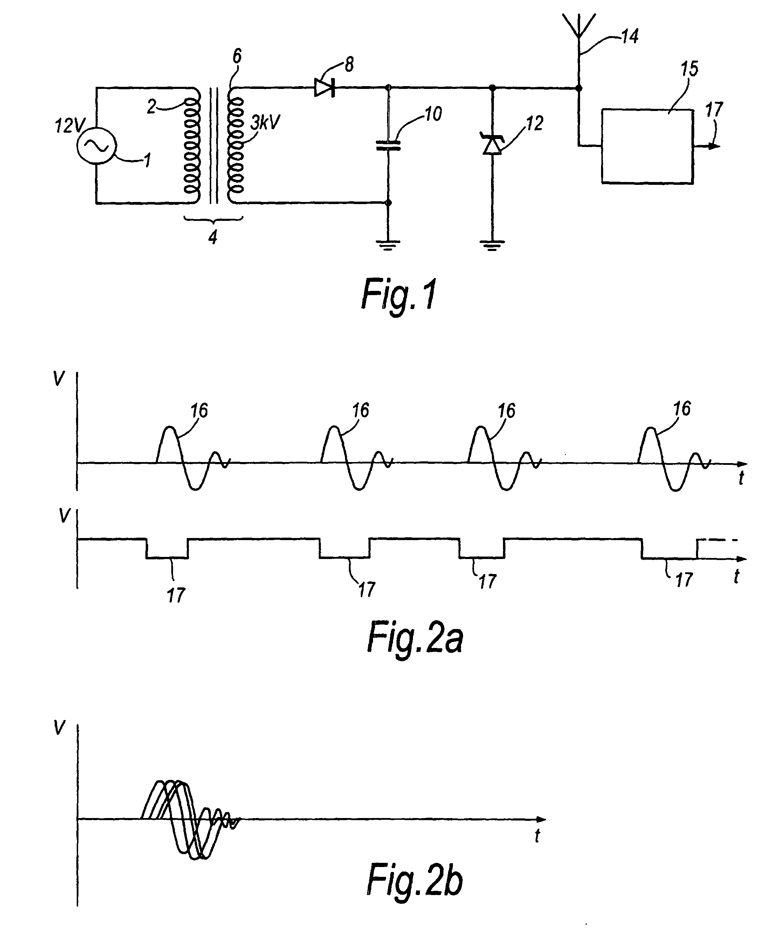

A known monopulse generator is shown in circuit diagram form in FIGURE 1. In Figure 1 a signal generator 1 is arranged to energise a primary coil 2 of a transformer 4. The transformer 4 is arranged to step up the voltage generated across the primary winding 2 so that a voltage generated across the secondary winding 6 is of a substantially greater magnitude. In this example, the signal generator 1 is arranged generate a peak to peak signal voltage of 12 volts and the stepped up peak to peak voltage across the secondary winding of the transformer 4 is arranged to be in the order of 3 kv. The signal across the secondary of the transformer is rectified by a rectifier means 8, so that a substantially DC voltage signal is arranged to charge a capacitor 10. The capacitor 10 is thereby charged with an increasing voltage determined by integrating the DC signal voltage generated by the rectifier means 8 in combination with the voltage generated across the secondary winding 6 of the transformer 4. Connected in parallel with the capacitor 10 is a breakdown or avalanche diode 12 which is reverse biased with respect to the capacitor 10, so that the avalanche diode 12 prevents capacitor 10 from discharging. However, in accordance with operating characteristics of the avalanche diode, when a breakdown voltage is reached, the avalanche diode 12 conducts in a substantially short time interval to the effect that energy in the capacitor 10 is suddenly discharged through the avalanche diode 12 generating a pulse of energy radiated by the antenna 14. Connected to the antenna 14 is a trigger pulse generator 15 which serves to generate a triggering pulse 17 in temporal correspondence with the generation of the pulse of energy radiated by the antenna 14. An effect of the monopulse generator shown in Figure 1 is illustrated schematically in Figure 2a in which there is shown a series of pulses of radiated energy 16, and triggering pulses 17, generated by the monopulse generator shown in Figure 1. Since the capacitor 10 is continuously charging and discharging as a result of the avalanche diode 12 conducting suddenly, the series of pulses of radiated energy represented by the waveform diagrams shown in Figure 2a and 2b, are generated repeatedly. However, a temporal position at which the pulses 16 are generated changes with respect to the trigger pulses 17, as a result of the time taken for the capacitor 10 to reach the breakdown voltage differing by small although significant amounts, and as a result of variations in the breakdown voltage of the avalanche diode 12. This is illustrated by a waveform diagram shown in Figure 2b where signal pulses 16 are shown to be superimposed with reference to the rising edge of the triggering pulses 17 which represents a common temporal reference. As can be seen, a result of the variation in the temporal position at which the pulses are generated, is that the superimposed pulses form a blurred pulse. This illustrates the aforementioned technical problem of a variation in a temporal position at which pulses from known monopulse generators are produced, resulting in pulses which do not have a clean and constant form. This technical problem is addressed by the monopulse generator according to the present invention as defined in Claim 1 and by the method according to Claim 10.

By deriving a switching signal from a repetitive waveform signal and arranging for the switching signal to switch at least part of one of the waveforms to appear at an output of the switch, monopulses are produced with substantially the same shape and energy which appear at the same temporal displacement with respect to each other. Although a switch used to generate the monopulse from the switching signal may introduce some uncertainty and therefore noise at a beginning section of the pulse and an end section of the pulse, at least on e part of the pulse will be the same and appear at the same point in time for all of the monopulses generated by the monopulse generator. It is an important advantage of the present invention that the pulses are reproduced accurately in both temporal position and pulse form.

The pulse selector may be a divider. The divider may include a clock recovery circuit coupled to the oscillator and arranged to generate a clock signal substantially in accordance with the predetermined frequency at which the oscillator is generating the repetitive wave form signal, and a divide by N counter coupled to the clock recovery circuit and arranged to generate one of said clock signals for every N generated by the clock recovery circuit, which clock signal forms the switching pulse. The integer N may be fixed or varied in accordance with a predetermined sequence of values.

The delay means may conveniently be coupled between the oscillator and the second input of the switch and may be a variable delay means facilitating adjustment of the part of the repetitive waveform which appears at the output. The repetitive waveform signal may be a sine wave.

The monopulse generator may be used in a surface penetrating radar system for detecting objects disposed on the other side of an intervening surface, said radar system comprising said monopulse generator coupled to an antenna, said monopulse generator being arranged to produce outward signal pulses of electro-magnetic radiation radiated by the antenna and a receiver which operates to detect return signal pulses appertaining to said propagated electro-magnetic pulses reflected from said objects and a controller which operates in combination with said receiver and said monopulse generator to determine a location of said objects from said radiating antenna in accordance with a difference in time when said outward pulses are transmitted and said return pulses are detected.

The receiver of the surface penetrating radar system may further operate to integrate detected reflected signals within each of a plurality of temporal windows, a art of which temporal windows are triggered with reference to the generation of said outward pulses.

The arrangement of the monopulse generator which generates pulses by passing the same part of a waveform generated from a repetitive waveform signal in accordance with a predetermined switching frequency, produces a pulse at the same temporal position with respect to a common temporal reference. As such, by accumulating detected signals at each of a plurality of sampling positions within a predetermined temporal window, for a number of such temporal windows, a reflected detected signal will sum at the same temporal position for each of the temporal windows, with the effect that a resolution provided by the surface penetrating radar is substantially increased. Correspondingly, the energy of the electro-magnetic pulse transmitted by the radar system may be substantially reduced.

According to a further aspect of the present invention there is provided for a method of generating a pulse of electromagnetic energy, comprising the steps of; generating a repetitive waveform signal at a predetermined frequency, selecting one of the waveforms of the repetitive waveform signal, forming a switching pulse from said selected waveform, switching said repetitive waveform signal from a first input of a switch to an output, in accordance with said switching pulse applied to a control input of said switch, thereby forming at said output said pulse of electromagnetic energy.

According to yet a further aspect of the present invention there is provided for a method of generating a pulse of electromagnetic energy wherein the step of selecting one of the waveforms of said repetitive waveform signal comprises the step of dividing said repetitive waveform signal by a predetermined factor, thereby generating said selected waveform at a rate determined by said predetermined frequency scaled by said predetermined factor.

One embodiment of the present invention will now be described by way of example only with reference to the accompanying drawings wherein:

FIGURE 3 is a schematic block diagram of a surface penetrating radar system,
FIGURE 4 is a schematic block diagram of

(a) a first monopulse signal generator according to the present invention, and
(b) a further monopulse signal generator according to the present invention,

FIGURE 5 is a set of three signal waveform diagrams,
FIGURE 6 is an illustrative representation of five waveform diagrams, showing the operation of the surface penetrating radar shown in Figure 3, and
FIGURE 7 is a schematic block diagram of a fast switch which appears in the monopulse signal generator illustrated in Figure 4.

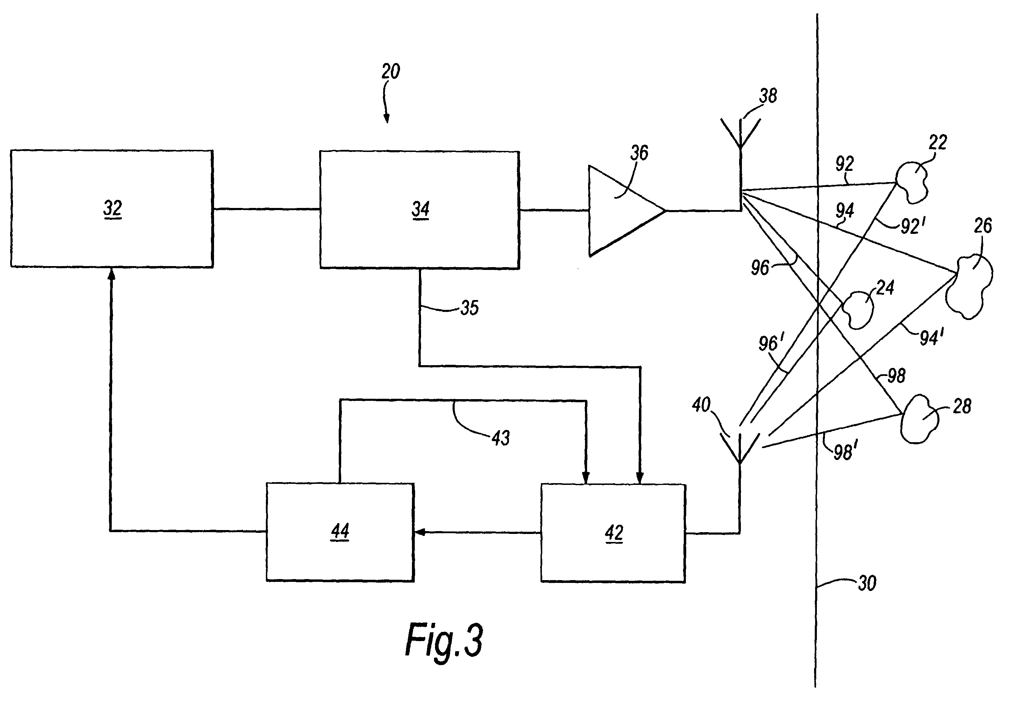

An embodiment of the present invention is illustrated in Figure 3, where a ground penetrating radar system 20 is shown in block diagram form. In Figure 3, four objects 22, 24, 26, 28, which may be non-metallic, are shown to be buried in the ground which is represented by the area to the right of line 30. The ground penetrating radar 20, comprises a user interface 32, connected to a monopulse generator 34. At a repetition rate determined by the user interface 32, the monopulse generator 34 operates to generate pulses of radio frequency energy which are amplified by an amplifier 36 and emitted towards the ground by an antenna 38. Also shown in Figure 3, is a receiving antenna 40, connected to a sampling receiver 42, to which is further connected a baseband processor 44. The baseband processor is also coupled to the user interface 32, and arranged to feed signals representative of an output of the ground penetrating radar 20.

The pulses of radio frequency energy emitted by antenna 38, towards the ground 30, are arranged to be directed towards a volume within which objects 22, 24, 26, 28, may be detected as a result of signals reflected from these objects. Paths of the radio frequency pulse from the transmitting antenna 38 to the receiving antenna 40, reflected via the buried objects 22, 24, 26, 28, are represented by the lines 92, 94, 96, 98. Radio frequency pulses emitted from the antenna 38 to the buried objects 22, 24, 26, 28, are represented by lines 92, 94, 96, 98, whereas pulses reflected from the buried objects 22, 24, 26, 28, and received by the antenna 40, are represented by the lines 92', 94', 96', 98'. Signals detected by the antenna 40 are fed to the sampling receiver 42, which serves to down convert to a baseband frequency the received signals, and which are thereafter fed to the baseband processor 44.

Objects below the surface of the ground 30, are detected from a time flight of signals from the transmit antenna 38 to the receive antenna 40, which is representative of a location of the buried objects 22, 24, 26, 28, below the surface of the ground 30. The time of flight of these signals is determined from the reflected signals from these objects. In combination with generating a monopulse, a triggering pulse is generated which serves to trigger a time base within the sampling receiver 42 and the baseband processor 44. Thereafter for a period until the next pulse is generated, sampling receiver 42, operates to detect signals arriving at the receiving antenna 40, as a function of time. In general the baseband processor 44 thereafter serves to store the received signals in a memory unit disposed therein. Analysis of the received signals, and in particular the versions of the pulse generated by the antenna 38 and received by the receiving antenna 40 reflected via buried objects, serves to determine a number and location of these objects below the surface of the ground 30. Alternatively a preferred operation of the sampling receiver 42 and baseband processor 44, which has an effect of obviating a limitation on a sampling interval which the receiver can achieve with the aforementioned method, will be described shortly.

In an alternative embodiment of the present invention, the ground penetrating radar system 20 can be used to determine the location of objects 22, 24, 26, 28 in which there is no physical obstruction between the antennas 38, 40 and said objects.

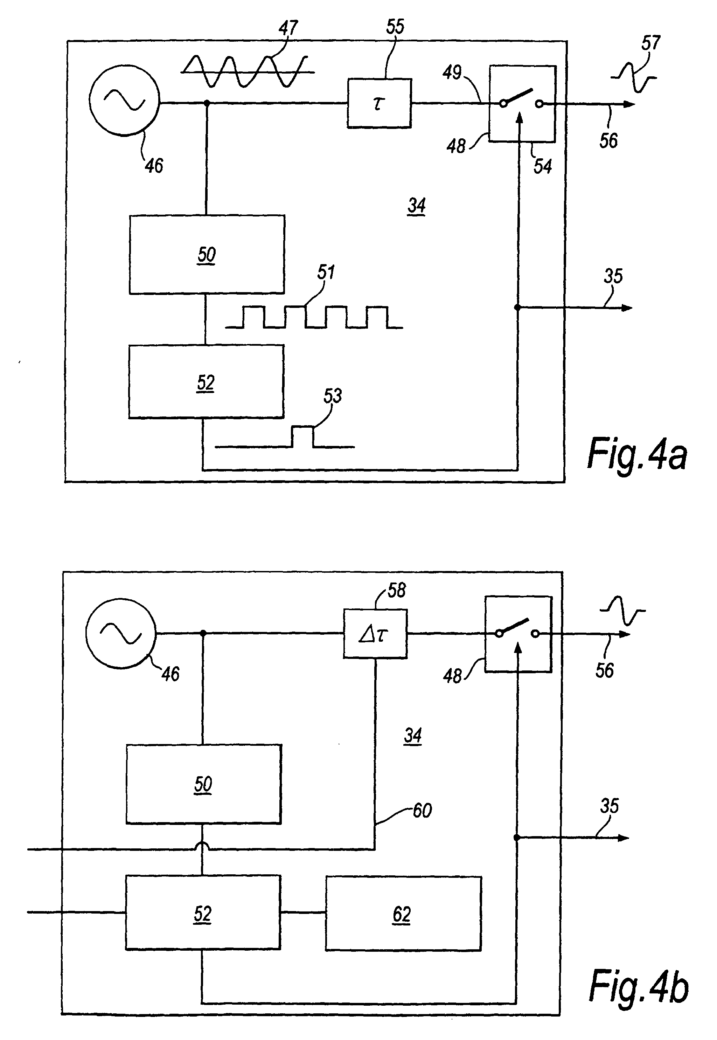

Two versions of the monopulse generator 34 are shown in Figures 4a and 4b respectively, where parts also appearing in Figure 3 bear identical numerical designations. In Figure 4a, the monopulse generator 34 is shown to be comprised of an oscillator 46, which is shown to generate a sine wave with a predetermined frequency. The sine wave generated by the oscillator 46 is shown conceptually by the line 47. The signal generated by the oscillator 46 is fed to an input of a fast switch 48 and to an input of a clock recovery circuit 50. The clock recovery circuit 50, operates to generate a clock signal at a phase and frequency corresponding to that of the sine wave generated by the oscillator 46. The signal generated by the clock recovery circuit 50 is represented by the waveform diagram 51, which is fed to an input of a divide by N circuit 52. The divide by N circuit 52, operates to generate a clock pulse corresponding to the clock pulses generated by the clock recovery circuit 50, for every N clock pulses received from the clock recovery circuit 50. This is illustrated by the waveform 53 which appears at an output of the divide by N circuit 52. The output from the divide by N circuit 52 also serves to provide the triggering pulse which is fed to an output conductor 35. The clock pulse generated by the divide by N circuit 52 is fed to a control input 54 of the fast switch 48. The fast switch 48, operates to switch the signal present on the input 49 of the switch 48 to the output 56 for a period when the clock pulse from the divide by N circuit 52 is high. The effect of this arrangement is that a part of the repetitive waveform signal, which is a sine wave generated by the oscillator 46, appears at an output 56 of the switch 48, which is also the output of the monopulse generator 34. An effect of the operation of the monopulse generator 34, is that a single pulse is generated at the output of the switch 56, for every N complete cycles of the sine wave generated by the oscillator 46. This is illustrated by the waveform 57. As will be described later, the triggering pulse determines the portion of the waveform 57 which is sampled.

The monopulse generator 34, shown in Figure 4a is also provided with a delay unit 55, coupled between the oscillator 46, and the fast switch 48. The delay units serves to compensate for a delay experienced by signals from the clock recovery circuit 50, and divide by N circuit 52, so that a part of the waveform of most effect appears at the output.

A further embodiment of the present invention is shown by the block diagram of Figure 4b, where parts appearing in Figure 4a bear identical numerical designations. In Figure 4b, the delay unit 55 has been replaced by a variable delay unit 58 between the oscillator 46 and the fast switch 48. The delay unit 58 is fed on a control input thereof by a conductor 60, which serves to alter an amount by which the signal generated by the oscillator 46 is delayed between the oscillator 46 and the switch 48. The effect of introducing a delay in the signal between the oscillator 46 and the switch 48 is to adjust a part of the repetitive waveform signal generated by the oscillator 46, which in this case is a sine wave, which appears at the output of the switch 56. Also shown in the monopulse generator 34 is the pseudo random generator 62, which operates to vary the factor N by which the divide by N circuit 52 divides the recovered clock signal 51, fed thereto from the clock recovery circuit 50. The pseudo random generator 62 operates to vary the factor N in a pseudo random manner, and by arranging for this pseudo random adjustment to be generated from an m- sequence, this change in the value of the factor N is effected in a predictable way. A result of this is that the radio frequency signal generated in accordance with the pulse signal will be difficult to detect by a third party and furthermore will substantially reduce interference to third parties. As will be appreciated, other ways of varying the factor N may be envisaged, such as stepping sequentially through a predetermined sequence of integers.

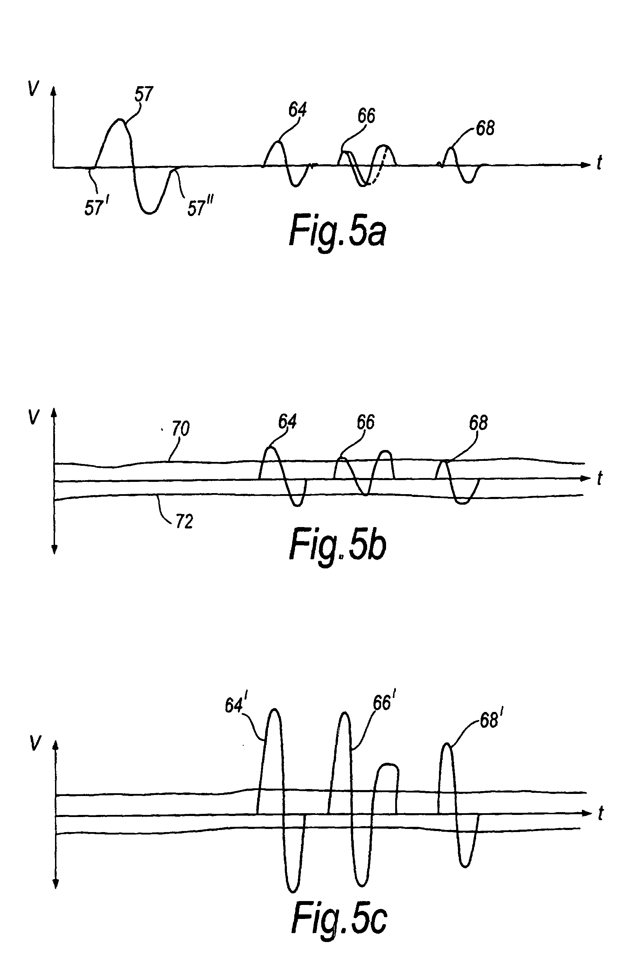

Operation of the monopulse generator 34, is further illustrated with respect to waveform diagrams shown in Figure 5. Figure 5a provides an illustrative waveform diagram of the pulse produced by the monopulse generator in combination with the amplifier 36 and the transmit antenna 38, and an example of signals detected by the receive antenna 40, in combination with the baseband processor 44 and the sampling receiver 42. In Figure 5a waveform 57 is illustrative of the pulse generated by the monopulse generator. As can be seen in Figure 5a, a start 57' and an end part 57" of the pulse 57 is shown to be comprised substantially of noise. This noise at the start and the end of the pulse 57 is as a result of an uncertainty in a period in which the switch 54 switches the input waveform to the output of the switch 56. However, in spite of the noise at the start and end of the pulse 57, the pulse 57 will always appear at substantially the same point in time, in that, part of the pulse between the start and the end parts of uncertainty will always be at substantially the same temporal position with the same amplitude and shape. Also shown in Figure 5a is a series of return waveforms generated as a result of the pulse 57 being reflected from the buried objects 22, 24, 26, 28, and received at the receive antenna 40. Thus, for example, waveform 64 is generated by reflected signals from object 22, waveform 66 is generated from reflected signals from objects 22 and 28, whereas waveform 68 is generated from reflected signals from buried object 26.

An example of the reflected waveforms as detected by the receiving antenna 40 in combination with the sampling receiver 42 is shown in Figure 5b. In Figure 5b, the waveforms 64, 66, 68, which appear in Figure 5a, are shown to be detected in the presence of noise which is illustrated by the lines 70, 72. With known systems, the signal waveforms 64, 66, 68, representative of signals reflected from the buried objects could not be detected above interfering noise signals illustrated between the lines 70, 72. However, since the monopulse generator 34 operates to generate the signal pulse waveform 57 at precisely the same point in time with precisely the same shape, by integrating the received signal waveforms detected within a predetermined temporal window starting from a time when the monopulse is generated, and by repeating this integration over correspondingly the same temporal window, repeated samples of the signal waveforms 64, 66, 68 will be added together constructively to generate amplified signals representative of the return pulses 64, 66, 68 from the buried objects, with a substantially increased amplitude determined in accordance with a number of repetitions over which integration is effected. Thus, in Figure 5c, the detected reflected waveforms are shown to be of increased amplitude and are represented as waveform 64', 66', 68'.

A preferred method of operation of the sampling receiver 42 and the baseband processor 44, to effect integration of the received return signals will now be described. As described above, the monopulse generator 34 provides the pulses of energy 57 which are radiated by the antenna. Referring back to Figure 3, the triggering pulse is provided on the further output conductor 35, which is fed to the sampling receiver 42. The baseband processor 44, provides on a conductor 43 control data representative of a delay. This delay is used in combination with the triggering pulse, to generate a sampling signal which determines a temporal position on the received signal which is sampled and passed to the baseband processor 44. The delay represented by the control data is maintained at substantially the same value for a plurality of triggering pulses, corresponding to a predetermined integration period, with the effect that the sample of the received signal may be summed over a corresponding plurality of samples of the received signals with the temporal position of the sampling point being maintained. The predetermined integration period therefore corresponds to a number of samples used to resolve the same temporal position within the temporal window of received signals. Thereafter, the baseband processor operates to increase the delay, and a sample of the received signal at this new temporal position is summed to build up an integrated overall sample. This has the effect of 'strobing' the sampling of the received return signals with the effect that the received signal may be built up with a substantially high signal to noise ratio.

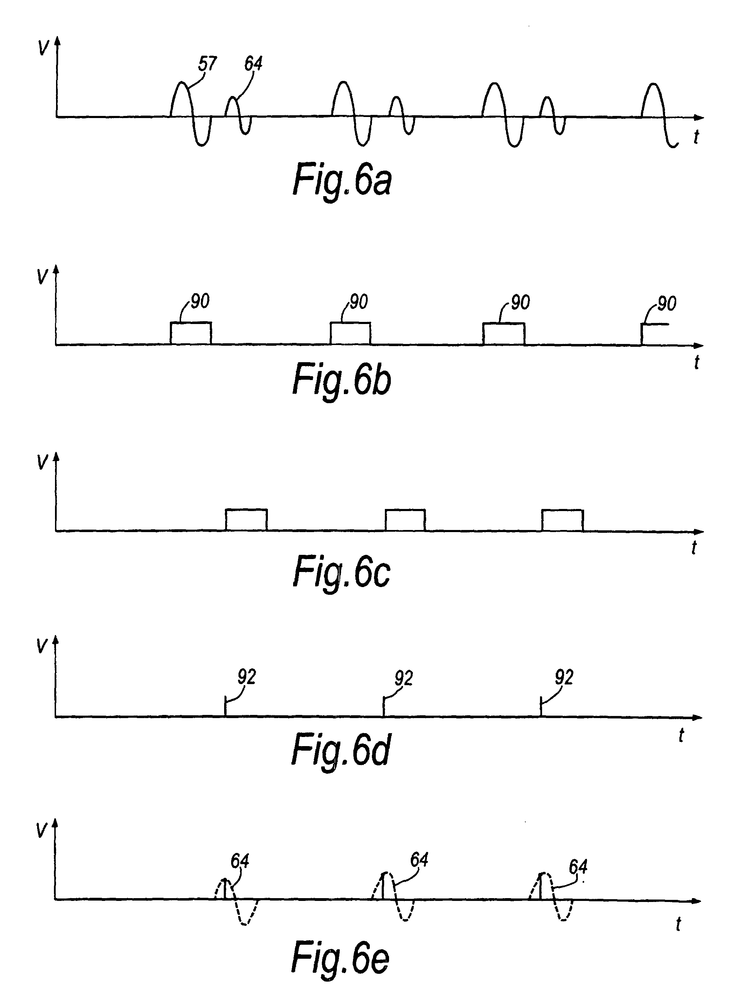

As an illustration of the operation of the baseband processor 44 and sampling receiver 42, Figure 6 provides a series of waveform diagrams illustrative of these operations. Figure 6a provides an illustration of the radiated outward pulses 57, together with an example of a return pulse 64. Correspondingly, the triggering pulses generated on conductor 35 are shown in Figure 6b as pulses 90. Figure 6c represents the effect of delaying the triggering pulses by an amount determined by the control data. Figure 6d shows how sampling impulses 92 are generated from the rising edge of the delayed triggering pulses 90. Finally Figure 6e shows how a sample of the received return signals are repetitively taken at the same point on the return pulses 64. It is the accuracy of the triggering pulse 90 which allows for the sample of the return pulse 64 to be taken at the same point, thereby giving a clean and constant sample signal. As will be appreciated, summing these sampled signal values at each of the same sampling instances, for a number of instances determined by the integration period, will have an effect of building an overall sample value with a high signal to noise ratio. It will furthermore be appreciated, that the sampling resolution will be determined by the increment in the delay introduced into the triggering pulse, thereby providing a high bandwidth resolution.

Integrated signals representative of the reflected monopulses from the buried objects 22, 24, 26, 28, appear in amplified form at the output of the baseband processor 44 and are fed to user interface 32. Thus, from knowledge of the point in time when the monopulse is generated and by identifying reflected waveforms 64', 66', 68', a location of the buried objects below the surface of the ground 30 may be determined. The embodiment of the present invention hereinbefore described therefore contributes a considerable technical advance over known monopulse generators and ground penetrating radar systems, in that by generating substantially the same waveform at the same point in time, the ground penetrating radar system may operate to integrate detected reflected signals from the buried objects so that an improvement in the resolution of detection is effected by building up substantially greater signal energy as a result of integrating the reflected signals over a large number of transmitted monopulses. The number of monopulses may be, for example, 1000 to 10,000. This technique of integrating the reflected signals over a predetermined time period, could not be effected with prior art ground penetrating radar systems and monopulse generators since ambiguity in the point in time and the waveform generated by the monopulse generators could not provide reflected signals at precisely the same point in time which therefore could not be integrated to improve the resolution with which buried objects are detected.

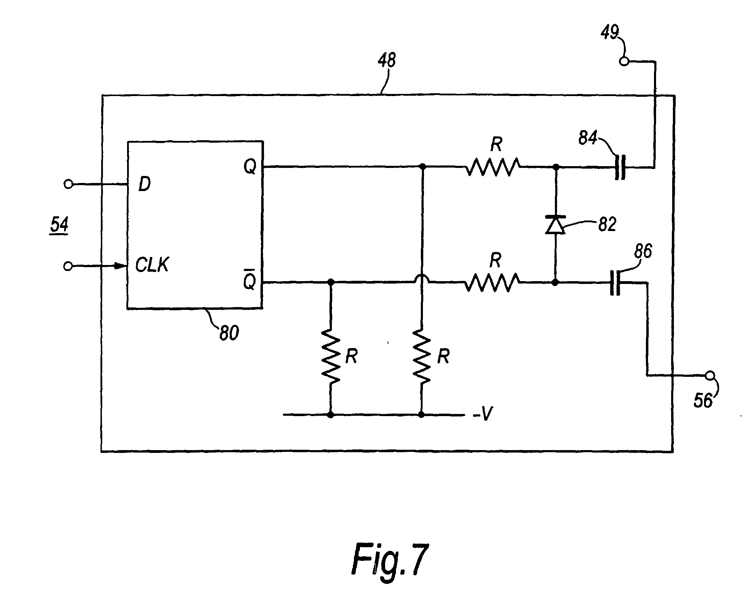

As will be appreciated by those skilled in the art, a limitation on a size of buried objects which may be detected with a monopulse generator is associated with a speed at which the fast switch 48 operates. Although the monopulse generator hereinbefore described is arranged to generate pulses of defined energy and shape at the same relative temporal position, the temporal length of these pulses, and hence the resolution which may be achieved will depend upon the speed at which the switch 48 can operate. Thus, to operate effectively the switching noise at the start and end of the pulse must be only around 10% of the temporal width of the pulse. By employing a fast switch 48, a resolution may be provided by an arrangement for a ground penetrating radar as hereinbefore described to the effect that buried objects such as pipes or golf balls may be detected. Such a switch is shown in Figure 7.

In Figure 7, the fast switch 48 is shown to be comprised of a D-type flip-flop 80 which has a $Q$ and a $\overline{Q}$ outputs which serve to generate dc voltages of + V and -V respectively when the control input 54 is at a low dc voltage. Connected between the input of switch 49 and the output of the switch 56, is a diode 82, which is ac coupled to the input 49 and output 56 via capacitor 84, 86. The circuit is completed by biasing resistors R which arrange for the $Q$ and $\overline{Q}$ outputs from the flip-flop 80 to be coupled to the anode and cathode of the diode 82. The biasing resistors R serve to maintain the diode 82 in reverse bias mode whilst the flip-flop 80 is arranged to be in a first mode when the $Q$ and $\overline{Q}$ output generates a positive dc voltage +V and output generates the negative dc voltage -V. It is a feature of this switch 48 that the flip-flop 80 is comprised of emitter coupled logic gates which have a switching time in the order of 50 psec. However, as will be appreciated other semiconductor active components or transistor switches may also be used. As a result, when the switching pulse is received and applied to the input 54 of the flip-flop 80, the flip-flop switches such that the $\overline{Q}$ output is positive +V whilst the $Q$ output is negative -V. This has the effect of forward biasing the diode 82 which in turn has the effect that the input 49 is connected to the output 56, thereby passing the signal from the input 49 to the output 56 whilst the control input 54 is high. With this switch arrangement a switching time in the order of pico seconds may be effected, such that the uncertainty period shown on the waveform 57 at the start and end of the waveform may be in the order of less than 10% of the cycle, when the monopulse generator generates 500ps pulses.

As will be appreciated by those skilled in the art, various other forms of waveform could be used for the monopulse. For example, the oscillator 46 could generate a triangular wave or a square wave. However, it is an arrangement of recovering the clock signal using a clock recovery circuit 50, and dividing this clock by a factor N to produce a clock pulse for every N clock pulses received from the clock recovery circuit, and using this recovered clock pulse to trigger a switch, which ensures that the same part of a repetitive waveform is generated by the monopulse generator, at substantially the same temporal position.

As will be appreciated by those skilled in the art, various modifications may be made to the aforementioned embodiment whilst still falling within the scope of the present invention. For example, the monopulse generator could be used in various other types of radar.

**Claims**

1. A monopulse generator (34) comprising an oscillator (46) which operates to generate a repetitive waveform signal having substantially the same waveform pattern repeated with a predetermined frequency, a pulse selector (50,52) coupled to said oscillator which operates to generate a switching pulse from said repetitive waveform signal generated by said oscillator, which switching pulse is fed to a control input (54) of a switch (48), a signal input (49) of said switch being fed by said repetitive waveform signal wherein said switch operates to pass at least a substantial part of one of said waveform patterns to an output thereof in accordance with said switching pulse, thereby generating at the output of the monopulse generator a pulse with a shape corresponding to the at least substantial part of the repetitive waveform pattern, **characterised in** including a delay means (55) arranged to delay said repetitive waveform signal provided to the signal input of said switch to compensate for a delay by which the pulse selector provides said said switching pulse to said switch, thereby determining a part of said repetitive waveform which appears at the output of said switch.

2. A monopulse generator as claimed in claim 1, wherein the pulse selector is a divider (52), which divides said repetitive waveform signal by a predetermined factor N thereby generating said switching pulse at a rate determined by the predetermined frequency in combination with said predetermined factor N.

3. A monopulse generator as claimed in claim 2, wherein said divider (52) operates to generate said switching pulse by dividing said repetitive waveform signal by said predetermined factor N which predetermined factor N varies between a range of predetermined integers.

4. A monopulse generator as claimed in claim 2, wherein said divider (52) operates to generate said switching pulse by dividing said repetitive waveform signal by said predetermined factor which is a fixed integer N.

5. A monopulse generator as claimed in any of claims 2 to 4, wherein said divider (52) includes a clock recovery circuit (50) coupled to said oscillator and arranged to generate a clock signal substantially in phase with and at substantially the same frequency as said predetermined frequency of said the repetitive waveform signal, and a divide by N counter coupled to said clock recovery circuit and arranged to generate at an output thereof one of said clock signals for every N repetitive waveforms applied to an input thereof, which clocks signal is used to form the switching pulse.

6. A monopulse generator as claimed in claim 1, wherein said delay means (55) is coupled between the signal input (49) of said switch (48) and said oscillator.

7. A monopulse generator as claimed in claims 1 or 6, wherein said delay means (55) is a variable delay means.

8. A monopulse generator as claimed in any preceding claim wherein said switching pulse is fed to a second output of said monopulse generator which serves to provide a triggering signal for use as a temporal reference.

9. A monopulse generator as claimed in any preceding claim, wherein the repetitive waveform is a sine wave.

10. A method of generating a pulse of electromagnetic energy, comprising the steps of; generating a repetitive waveform signal having substantially the same waveform pattern repeats with a predetermined frequency, selecting one of the waveforms of the repetitive waveform signal, forming a switching pulse from said selected waveform, switching said repetitive waveform signal from a signal input of a switch to an output, in accordance with said switching pulse applied to a control input of said switch, thereby forming at said output, said pulse of electromagnetic energy, **characterised in** including delaying, arranged to compensate to for an amount including a delay means (55) arranged to delay said repetitive waveform signal provided to said signal input of said switch to compensate for a delay by which said switching pulse is obtained by the selecting and forming steps, thereby determining a part of said repetitive waveform which appears at the output of said switch.

11. A method of generating a pulse of electromagnetic energy as claimed in claim 10, wherein the step of selecting one of the waveforms of said repetitive waveform signal comprises the step of dividing said repetitive waveform signal by a predetermined factor, thereby generating said selected waveform at a rate determined by said predetermined frequency scaled by said predetermined factor.

12. A method of generating a pulse of electromagnetic energy as claimed in claim 11, wherein said predetermined factor is varied between a sequence of predefined integers.

13. Use of a monopulse generator as claimed in any of claims 1 to 9 in a surface penetrating radar system for detecting objects disposed on the other side of an intervening surface, said radar system comprising said monopulse generator coupled to an antenna, said monopulse generator being arranged to produce outward signal pulses of electro-magnetic radiation radiated by the antenna and a receiver which operates to detect return signal pulses appertaining to said electro-magnetic pulses reflected from said objects and a controller which operates in combination with said receiver and said monopulse generator to determine a location of said objects from said radiating antenna in accordance with a difference in time when said outward pluses were transmitted and said return pulses were detected.

14. Use of a monpulse generator as claimed in claim 13, wherein said receiver operates to detect said reflected electromagnetic pulses, and to accumulate said detected reflected signals, within each of a plurality of predetermined temporal windows, associated with a time when said electromagnetic pulses are generated.

15. Use of a monopulse generator as claimed in claim 14, wherein said monopulse generator is arranged to provide at a second output thereof said switching pulse, and said second output is fed to a control input of said receiver which serves to provide a temporal reference for said predetermined temporal windows.

16. Use of a monpulse generator as claimed in claim 15, wherein said receiver generates a sampling instant from said temporal reference in combination with a delay, which delay is representative of a temporal displacement within said predetermined temporal windows, and said receiver generates a sample of said detected reflected signals at said sampling instant for each of a number of said predetermined temporal window, which number is determined by an integration period, said samples being accumulated to provide a composite sample of said detected reflected signals.

17. The use of a monopulse generator as claimed in any of claims 14 to 16, wherein said pulse selector of said monopulse generator is a divider which divides said repetitive waveform signal by a predetermined factor.

**Patentansprüche**

1. Monopuls-Generator (34), welcher umfasst: einen Oszillator (46), dessen Funktion darin besteht, ein periodisches Wellenformsignal zu erzeugen, bei dem sich im Wesentlichen dasselbe Wellenform-Muster mit einer vorgegebenen Frequenz wiederholt, einen mit dem besagtem Oszillator gekoppelten Impulswähler (50, 52), dessen Funktion darin besteht, aus dem besagten, von dem besagten Oszillator erzeugten periodischen Wellenformsignal einen Schaltimpuls zu erzeugen, wobei dieser Schaltimpuls einem Steuereingang (54) eines Schalters (48) zugeführt wird, wobei einem Signaleingang (49) des besagten Schalters das besagte periodische Wellenformsignal zugeführt wird, wobei der besagte Schalter bewirkt, dass wenigstens ein wesentlicher Teil eines der besagten Wellenform-Muster entsprechend dem besagten Schaltimpuls zu einem Ausgang des Schalters geleitet wird, wodurch am Ausgang des Monopuls-Generators ein Impuls mit einer Form erzeugt wird, welche dem wenigstens wesentlichen Teil des periodischen Wellenform-Musters entspricht, **dadurch gekennzeichnet, dass** er ein Verzögerungsmittel (55) umfasst, das so beschaffen ist, dass es das besagte periodische Wellenformsignal, das dem Signaleingang des besagten Schalters zugeführt wird, verzögert, um eine Verzögerung zu kompensieren, mit welcher der Impulswähler den besagten Schaltimpuls dem besagten Schalter zuführt, wobei er dadurch einen Teil der besagten periodischen Wellenform bestimmt, welcher am Ausgang des besagten Schalters erscheint.

2. Monopuls-Generator nach Anspruch 1, wobei der Pulswähler ein Teiler (52) ist, welcher das besagte periodische Wellenformsignal durch einen vorgegebenen Faktor N teilt, wodurch er den besagten Schaltimpuls mit einer Impulsrate erzeugt, die von der vorgegebenen Frequenz in Verbindung mit dem besagten vorgegebenen Faktor N bestimmt wird.

3. Monopuls-Generator nach Anspruch 2, wobei der besagte Teiler (52) die Erzeugung des besagten Schaltimpulses durch Teilen des besagten periodischen Wellenformsignals durch den besagten vorgegebenen Faktor N bewirkt, wobei dieser vorgegebene Faktor N innerhalb einer Reihe von vorgegebenen ganzen Zahlen variiert.

4. Monopuls-Generator nach Anspruch 2, wobei der besagte Teiler (52) die Erzeugung des besagten Schaltimpulses durch Teilen des besagten periodischen Wellenformsignals durch den besagten vorgegebenen Faktor bewirkt, welcher eine feste ganze Zahl N ist.

5. Monopuls-Generator nach einem der Ansprüche 2 bis 4, wobei der besagte Teiler (52) eine Taktrückgewinnungsschaltung (50) enthält, die mit dem besagten Oszillator gekoppelt ist und so beschaffen ist, dass sie ein Taktsignal erzeugt, das im Wesentlichen mit dem besagten periodischen. Wellenformsignal in Phase ist und dessen Frequenz im Wesentlichen mit der besagten vorgegebenen Frequenz des besagten periodischen Wellenformsignals übereinstimmt, und einen Zähler zur Division durch N, der mit der Taktrückgewinnungsschaltung gekoppelt ist und so beschaffen ist, dass er für jeweils N periodische Wellenformen, die an einen Eingang des Zählers angelegt werden, an einem Ausgang des Zählers eines der besagten Taktsignale erzeugt, wobei dieses Taktsignal verwendet wird, um den Schaltimpuls zu formen.

6. Monopuls-Generator nach Anspruch 1, wobei das besagte Verzögerungsmittel (55) zwischen den Signaleingang (49) des besagten Schalters (48) und den besagten Oszillator geschaltet ist.

7. Monopuls-Generator nach Anspruch 1 oder 6, wobei das besagte Verzögerungsmittel (55) ein variables Verzögerungsmittel ist.

8. Monopuls-Generator nach einem der vorhergehenden Ansprüche, wobei der besagte Schaltimpuls einem zweiten Ausgang des besagten Monopuls-Generators zugeführt wird, welcher dazu dient, ein Triggersignal zur Verwendung als zeitlicher Bezugspunkt zur Verfügung zu stellen.

9. Monopuls-Generator nach einem der vorhergehenden Ansprüche, wobei die periodische Wellenform eine Sinuswelle ist.

10. Verfahren zur Erzeugung eines Impulses von elektromagnetischer Energie, welches die folgenden Schritte umfasst: Erzeugen eines periodischen Wellenformsignals, bei dem sich im Wesentlichen dasselbe Wellenform-Muster mit einer vorgegebenen Frequenz wiederholt, Wählen einer der Wellenformen des periodischen Wellenformsignals, Formen eines Schaltimpulses aus der besagten gewählten Wellenform, Schalten des besagten periodischen Wellenformsignals von einem Signaleingang eines Schalters zu einem Ausgang entsprechend dem besagten Schaltimpuls, der an einen Steuereingang des besagten Schalters angelegt wird, wodurch der besagte Impuls von elektromagnetischer Energie an dem besagten Ausgang geformt wird, **dadurch gekennzeichnet, dass** es ein Verzögern mittels eines Verzögerungsmittels (55) umfasst, das so beschaffen ist, dass es das besagte periodische Wellenformsignal, das dem Signaleingang des besagten Schalters zugeführt wird, verzögert, um eine Verzögerung zu kompensieren, mit welcher der besagte Schaltimpuls durch die Schritte des Wählens und Formens erhalten wird, wodurch ein Teil der besagten periodischen Wellenform bestimmt wird, welcher am Ausgang des besagten Schalters erscheint.

11. Verfahren zur Erzeugung eines Impulses von elektromagnetischer Energie nach Anspruch 10, wobei der Schritt des Wählens einer der Wellenformen des besagten periodischen Wellenformsignals den Schritt des Teilens des besagten periodischen Wellenformsignals durch einen vorgegebenen Faktor umfasst, wodurch die besagte gewählte Wellenform mit einer Rate erzeugt wird, die von der besagten vorgegebenen Frequenz, skaliert mit dem vorgegebenen Faktor, bestimmt wird.

12. Verfahren zur Erzeugung eines Impulses von elektromagnetischer Energie nach Anspruch 11, wobei der besagte vorgegebene Faktor innerhalb einer Folge von vordefinierten ganzen Zahlen variiert wird.

13. Verwendung eines Monopuls-Generators nach einem der Ansprüche 1 bis 9 in einer Oberflächen durchdringenden Radaranlage zum Aufspüren von Objekten, die sich jenseits einer dazwischen liegenden Oberfläche befinden, wobei die besagte Radaranlage umfasst: den besagten mit einer Antenne gekoppelten Monopuls-Generator, wobei der besagte Monopuls-Generator so beschaffen ist, dass er abgehende Signalimpulse von elektromagnetischer Strahlung erzeugt, die von der Antenne ausgestrahlt werden, und einen Empfänger, welcher in der Lage ist, Echosignalimpulse zu erfassen, die zu den besagten elektromagnetischen Impulsen gehören, welche von den besagten Objekten reflektiert wurden, und ein Steuergerät, welches in Verbindung mit dem besagten Empfänger und dem besagten Monopuls-Generator in der Lage ist, eine Position der besagten Objekte bezüglich der besagten ausstrahlenden Antenne entsprechend einer Differenz zwischen dem Zeitpunkt, zu dem die besagten abgehenden Impulse gesendet wurden, und dem Zeitpunkt, zu dem die besagten Echoimpulse erfasst wurden, zu bestimmen.

14. Verwendung eines Monopuls-Generators nach Anspruch 13, wobei der besagte Empfänger die Funktion erfüllt, die besagten reflektierten elektromagnetischen Impulse zu erfassen und die besagten erfassten reflektierten Signale innerhalb jedes Zeitfensters aus einer Vielzahl von vorgegebenen Zeitfenstern, die mit einem Zeitpunkt verknüpft sind, zu dem die besagten elektromagnetischen Impulse erzeugt werden, zu akkumulieren.

15. Verwendung eines Monopuls-Generators nach Anspruch 14, wobei der besagte Monopuls-Generator so beschaffen ist, dass er an einem zweiten Ausgang des Monopuls-Generators den besagten Schaltimpuls liefert und der besagte zweite Ausgang einem Steuereingang des besagten Empfängers zugeführt, welcher dazu dient, eine Zeitreferenz für die besagten vorgegebenen Zeitfenster zur Verfügung zu stellen.

16. Verwendung eines Monopuls-Generators nach Anspruch 15, wobei der besagte Empfänger einen Sampling-Zeitpunkt aus der besagten Zeitreferenz in Verbindung mit einer Verzögerung erzeugt, wobei diese Verzögerung repräsentativ für eine zeitliche Verschiebung innerhalb der besagten vorgegebenen Zeitfenster ist, und wobei der besagte Empfänger ein Sample der besagten erfassten reflektierten Signale zu dem besagten Sampling-Zeitpunkt für jedes Zeitfenster aus einer Anzahl der besagten vorgegebenen Zeitfenster erzeugt, wobei diese Anzahl durch ein Integrations-Zeitintervall bestimmt wird und wobei die besagten Samples akkumuliert werden, um ein zusammengesetztes Sample der besagten erfassten reflektierten Signale zu liefern.

17. Verwendung eines Monopuls-Generators nach einem der Ansprüche 14 bis 16, wobei der besagte Impulswähler des besagten Monopuls-Generators ein Teiler ist, welcher das besagte periodische Wellenformsignal durch einen vorgegebenen Faktor teilt.

## Revendications

1. Un générateur monoimpulsion (34) comprenant un oscillateur (46) générant un signal à forme d'onde répétitive présentant en substance le même profil de forme d'onde répété à une fréquence prédéterminée, un sélecteur d'impulsions (50, 52) couplé à l'oscillateur, qui génère une impulsion de commutation au départ dudit signal à forme d'onde répétitive généré par ledit oscillateur, laquelle impulsion de commutation est transmise pour alimenter une entrée de contrôle (54) d'un commutateur (48), une entrée de signal (49) dudit commutateur étant alimentée par ledit signal à forme d'onde répétitive, ledit commutateur transmettant au moins une portion substantielle de l'un desdits profils de forme d'onde à une sortie de celui-ci, en concordance avec ladite impulsion de commutation, générant ainsi, à la sortie du générateur monoimpulsion, une impulsion de forme correspondant à la portion au moins substantielle du profil de forme d'onde répétitive, **caractérisée en ce qu'**elle comprend un dispositif de temporisation (55) configuré pour temporiser ledit signal à forme d'onde répétitive alimentant l'entrée du signal dudit commutateur pour compenser le délai de temporisation moyennant lequel le sélecteur d'impulsions transmet ladite impulsion de commutation au commutateur, déterminant par là même une portion de ladite forme d'onde apparaissant à la sortie dudit commutateur.

2. Un générateur monoimpulsion selon la revendication 1, dans lequel le sélecteur d'impulsions est un diviseur (52) servant à diviser le signal à forme d'onde répétitive par un facteur N prédéterminé, générant ainsi ladite impulsion de commutation à une vitesse déterminée par la fréquence prédéterminée combinée avec ledit facteur N prédéterminé.

3. Un générateur monoimpulsion selon la revendication 2, dans lequel ledit diviseur (52) génère ladite impulsion de commutation en divisant ledit signal à forme d'onde répétitive par ledit facteur N prédéterminé, ce dernier facteur N prédéterminé variant dans une plage de nombres entiers prédéterminés.

4. Un générateur monoimpulsion selon la revendication 2, dans lequel ledit diviseur (52) génère ladite impulsion de commutation en divisant ledit signal à forme d'onde répétitive par ledit facteur prédéterminé étant un nombre entier fixe N.

5. Un générateur monoimpulsion selon l'une quelconque des revendications 2 à 4, dans lequel ledit diviseur (52) comprend un circuit de récupération de rythme (50) couplé à l'oscillateur et configuré pour générer un signal d'horloge substantiellement en phase avec et à substantiellement la même fréquence que la fréquence prédéterminée dudit signal à forme d'onde répétitive, et un compteur de division par N couplé au circuit de récupération de rythme et configuré pour générer à sa sortie l'un desdits signaux d'horloge pour chaque N formes d'onde répétitive appliquées à une de ses entrées, lequel signal d'horloge est utilisé pour composer l'impulsion de déclenchement.

6. Un générateur monoimpulsion selon la revendication 1, dans lequel ledit dispositif de temporisation (55) est couplé entre l'entrée du signal (49) dudit commutateur (48) et ledit oscillateur.

7. Un générateur monoimpulsion selon les revendications 1 ou 6, dans lequel ledit dispositif de temporisation (55) est un dispositif de temporisation variable.

8. Un générateur monoimpulsion selon l'une quelconque des revendications précédentes, dans lequel ladite impulsion de commutation est transférée à une seconde sortie dudit générateur monoimpulsion, laquelle sert à produire un signal de déclenchement à utiliser comme référence temporelle.

9. Un générateur monoimpulsion selon l'une quelconque des revendications précédentes, dans lequel la forme d'onde répétitive est une onde sinusoïdale.

10. Une méthode de génération d'une impulsion d'énergie électromagnétique comprenant les étapes suivantes : la génération d'un signal à forme d'onde répétitive présentant substantiellement le même profil de forme d'onde répété selon une fréquence prédéterminée ; la sélection de l'une des formes d'onde du signal à forme d'onde répétitive, la formation d'une impulsion de commutation au départ de ladite forme d'onde sélectionnée ; la commutation dudit signal à forme d'onde répétitive entre une entrée de signal d'un commutateur et une sortie, en correspondance avec ladite impulsion de déclenchement appliquée à une entrée de contrôle dudit commutateur, formant ainsi, au niveau de ladite sortie, ladite impulsion d'énergie électromagnétique **caractérisée en ce qu'**elle prévoit un délai de temporisation configuré pour permettre une compensation correspondant à une valeur donnée, en ce compris un dispositif de temporisation (55) configuré pour temporiser ledit signal à forme d'onde répétitive transmis à ladite entrée de signal dudit commutateur, afin de compenser le retard grâce auquel ladite impulsion de commutation est obtenue au moyen des étapes de sélection et de formation, déterminant ainsi une portion de ladite forme d'onde répétitive apparaissant à la sortie dudit commutateur.

11. Une méthode de génération d'une impulsion d'énergie électromagnétique selon la revendication 10, où l'étape de sélection de l'une des formes d'onde dudit signal à forme d'onde répétitive comprend l'étape de division dudit signal à forme d'onde répétitive par un facteur prédéterminé, générant ainsi ladite forme d'onde sélectionnée à un rythme déterminé par ladite fréquence prédéterminée dont l'échelle est ainsi réduite par ledit facteur prédéterminé.

12. Une méthode de génération d'une impulsion d'énergie électromagnétique selon la revendication 11, où ledit facteur prédéterminé varie dans une séquence de nombres entiers prédéfinis.

13. L'utilisation d'un générateur monoimpulsion selon l'une quelconque des revendications 1 à 9 dans un système de radar à pénétration de surface pour détecter des objets disposés sur la face opposée de la surface intercalaire, ledit système de radar comprenant ledit générateur monoimpulsion couplé à une antenne, ledit générateur monoimpulsion étant configuré pour produire comme signal de sortie des impulsions d'énergie électromagnétique rayonnées par l'antenne et comportant un récepteur opérant en détectant les impulsions d'écho du signal correspondant auxdites impulsions électromagnétiques réfléchies par lesdits objets, ainsi qu'un contrôleur fonctionnant en combinaison avec ledit récepteur et ledit générateur monoimpulsion pour déterminer la position desdits objets au départ de l'antenne de rayonnement, en fonction de la différence temporelle entre le moment où lesdites impulsions de sortie ont été émises et le moment où lesdites impulsions d'écho ont été détectées.

14. L'utilisation d'un générateur monoimpulsion selon la revendication 13, où ledit récepteur détecte lesdites impulsions électromagnétiques réfléchies et additionne lesdits signaux réfléchis qu'il a détectés dans chacune des diverses fenêtres temporelles prédéterminées en correspondance avec le moment où lesdites impulsions électromagnétiques ont été générées.

15. L'utilisation d'un générateur monoimpulsion selon la revendication 14, où ledit générateur monoimpulsion est configuré pour fournir, à une seconde de ses sorties, ladite impulsion de commutation, cette seconde valeur de sortie étant transmise à une entrée de contrôle dudit récepteur lequel sert à produire une référence temporelle pour lesdites fenêtres temporelles prédéterminées.

16. L'utilisation d'un générateur monoimpulsion selon la revendication 15, où ledit récepteur génère un instant d'échantillonnage au départ de ladite référence temporelle combinée à un délai de temporisation, lequel délai est représentatif d'un décalage temporel au sein desdites fenêtres temporelles prédéterminées, ledit récepteur générant un échantillon desdits signaux réfléchis détectés à l'instant d'échantillonnage pour chacun d'un certain nombre des fenêtres temporelles prédéterminées, ce nombre étant déterminé par une période d'intégration et lesdits échantillons étant cumulés pour fournir un échantillon composé desdits signaux réfléchis détectés.

17. L'utilisation d'un générateur monoimpulsion selon l'une des revendications 14 à 16, où ledit sélecteur d'impulsions dudit générateur monoimpulsion est un diviseur divisant ledit signal à forme d'onde répétitive par un facteur prédéterminé.

Fig.1

Fig.2a

Fig.2b

*Fig.3*

*Fig.4a*

*Fig.4b*

Fig.5a

Fig.5b

Fig.5c

*Fig.6a*

*Fig.6b*

*Fig.6c*

*Fig.6d*

*Fig.6e*

Fig.7